# FASCICULE DE BREVET EUROPEEN

(11) **EP 0 465 353 B1**
(45) Date de publication et mention de la délivrance du brevet: **09.11.1994**
(21) Numéro de dépôt: 91401825.4
(22) Date de dépôt: 03.07.1991
(51) Int. Cl.: C30B 11/00, C30B 29/52, B22C 9/08

(54) **Moule de fonderie pour la fabrication de pièces par solidification monocristalline**
Giessform zur Herstellung von Gegenständen durch Einkristallerstarrung
Foundry mould for casting articles by single crystal solidification

(30) Priorité: 04.07.1990 FR 9008446
(43) Date de publication de la demande: 08.01.1992
(73) Titulaire: SOCIETE NATIONALE D'ETUDE ET DE CONSTRUCTION DE MOTEURS D'AVIATION, "S.N.E.C.M.A.", F-75015 Paris (FR)
(72) Inventeur: Lamanthe, Ghislaine Elisabeth, Setagaya-ku, Tokyo 154 (JP); Lallement, Bernard Louis, F-95600 Eaubonne (FR); Puissant, Alain, F-57110 Yutz (FR)
(74) Mandataire: Berrou, Paul

(56) Documents cités:
- EP-A- 0 066 971
- EP-A- 0 082 100
- FR-A- 2 093 971
- US-A- 3 810 504

## Description

L'invention concerne un moule de fonderie utilisé dans un procédé de fabrication de pièces par solidification monocristalline, notamment des aubes pour turbomachines en superalliage.

Selon ce procédé et par des techniques connues en soi, on alimente le moule en métal fondu à sa partie supérieure et on opère une solidification dirigée dont le front progresse verticalement de bas en haut, à partir d'une sole refroidie. Dans l'application particulière à des pièces monocristallines, un dispositif de sélection placé à la partie inférieure du moule permet de sélectionner à sa sortie un grain de cristal unique. Des exemples de procédés de fabrication de ce type, en fonderie, pour des pièces monocristallines sont notamment décrits par FR-A-1 481 366 et FR-A-2 037 187.

Diverses solutions ont été appliquées pour obtenir une orientation cristallo-graphique déterminée sur la pièce et opérer une sélection de grain adéquate. Dans certaines applications toutefois, notamment pour obtenir des aubes monocristallines à plate-forme, il subsiste de sérieuses difficultés de mise en oeuvre de ces procédés connus. En effet, l'apparition d'un grain parasite au niveau de la plate-forme d'aube soit interdit la réalisation de certaines formes géométriques, soit impose des mises au point longues, délicates, coûteuses et rarement suffisantes, soit entraîne des rebuts de pièces trop nombreux. Cette germination parasite observée dans ce cas est dûe à un refroidissement plus rapide et prématuré de la plate-forme d'aube qui provoque une solidification de la plate-forme à partir de sa périphérie, indépendamment du reste de l'aube. Ce phénomène peut être favorisé par divers facteurs.

Dans la réalisation d'un monocristal, il est nécessaire de faire croître un germe initial dans un volume avant qu'aucun point de celui-ci n'ait atteint la température du liquidus de l'alliage considéré. Cette condition est difficilement maîtrisée dans le cas d'une plate-forme d'aube pour laquelle le gradient thermique est naturellement orienté dans une direction perpendiculaire aux grandes dimensions, longueur et largeur de la plate-forme.

Une germination d'un grain parasite est également provoquée sur une plate-forme d'aube par une germination hétérogène qui est également favorisée, dans le cas des plates-formes, par les conditions suivantes :
- rugosité élevée du moule au moment de la solidification et qui peut être accrue au cours de la coulée du fait de la réactivité entre le métal et la carapace de moule, à haute température ;
- grand rapport de surface sur volume ;
- présence de points anguleux.

Dans ces conditions, la surfusion admissible ou retard à la solidification ne peut pas dépasser quelques degrés. Par suite, dès que les parois du moule et un élément de volume de la plate-forme atteignent la température du liquidus de l'alliage coulé, un risque de germination parasite et de croissance d'un grain apparaît, générateur du défaut sur la pièce.

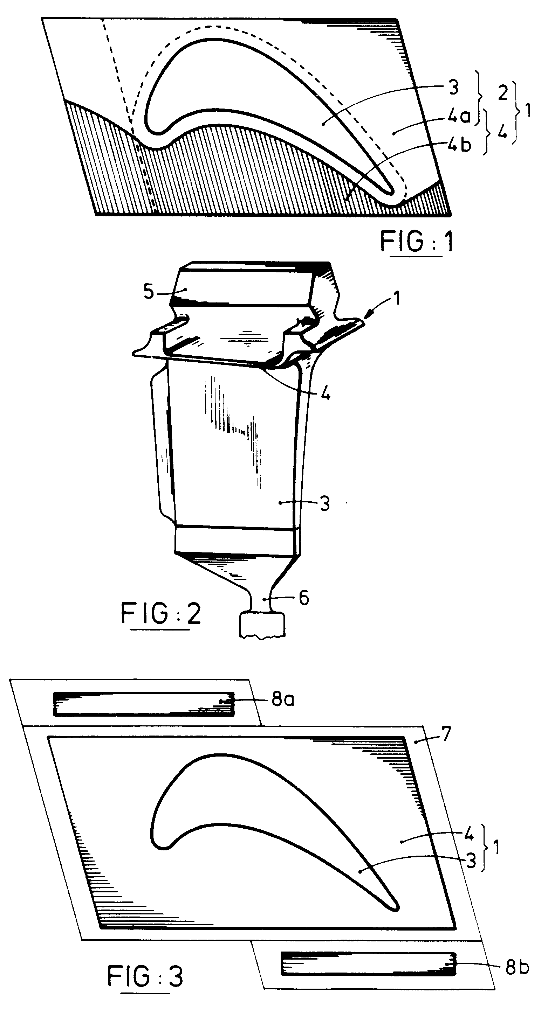

La figure 1 montre un exemple de pièce monocristalline constituée par une aube 1 représentée en vue de dessus. La partie 2 est le grain issu du germe initial et comporte la pale 3 d'aube et une partie 4a de la plate-forme 4 qui présente dans ce cas deux grandes dimensions, longueur et largeur par rapport à son épaisseur. Un grain parasite s'est développé dans la partie 4b de ladite plate-forme;

Une tentative de solution a consisté à disposer un canal parallèle d'amenée de grain, reliant la sortie du sélecteur de grain à la zone à risque de la plate-forme d'aube. Ainsi, l'orientation initiale est reproduite au point froid de la plate-forme où le grain croît simultanément avec celui en provenance de la partie centrale de l'aube ; les deux parties du grain sont ensuite recollées. Cette technique n'est pas toutefois sans risque ni inconvénient et impose toujours une mise au point délicate, longue et spécifique à chaque pièce. Le canal d'amenée attenant à la pièce exige un travail minutieux pour sa mise en place et son enlèvement, par exemple par tronçonnage qui nécessite ensuite un parachèvement. Des désorientations peuvent être observées au recollement de grain et la présence de l'amenée peut dans certains cas être à l'origine de grains recristallisés. Tous ces inconvénients sont défavorables à une application industrielle de cette solution lors d'une production de pièces en série.

Selon l'invention, un moule de fonderie répondant à ces conditions est caractérisé en ce qu'il comporte au moins une masselotte, placée au voisinage des zones de pièce où est susceptible d'apparaître une germination de grain parasite en cours de solidification dirigée, ladite masselotte formant une masse thermique qui ralentit la solidification de ladite zone concernée par échange thermique avec celle-ci et qui est séparée de la pièce coulée.

Avantageusement, ladite masselotte est constituée d'un métal subissant une transformation de phase à la même température ou légèrement inférieure à celle du métal constituant la pièce à solidifier.

Dans le cas d'une aube à plate-forme, avantageusement, une masselotte formant masse thermique est disposée de chaque côté de la plate-forme et à son voisinage.

D'autres caractéristiques et avantages de l'invention seront mieux compris à la lecture de la description qui va suivre d'un mode de réalisation de l'invention, en référence aux dessins annexés sur lesquels :
- la figure 1 précédemment décrite représente une aube obtenue en fonderie monocristalline en vue de dessus, montrant un défaut de grain parasite, en l'absence des dispositions prévues par l'invention ;
- la figure 2 représente schématiquement une vue de face de montage d'aube dans une grappe de coulée ;
- la figure 3 représente schématiquement, selon une vue de dessous, une aube monocristalline et le moule correspondant, selon un mode de réalisation de l'invention.

Les techniques de fabrication de pièces en fonderie par solidification monocristalline sont notamment appliquées pour des aubes de turbomachine. Un exemple d'une telle aube 1 est montré sur la figure 2. L'aube 1 comporte un pied 5 et une pale 3, entre lesquels est disposée une plate-forme 4. L'aube 1 est représentée dans la position verticale occupée dans une grappe de coulée, une liaison 6 au sélecteur de grain étant schématiquement représentée à la partie inférieure raccordée à la pale 3.

La figure 3 montre schématiquement en vue de dessous une aube 1 avec sa pale 3 et sa plate-forme 4. Un moule 7 a été schématisé en traits fins. De manière remarquable et conforme à l'invention, ledit moule 7 comporte deux masselottes 8a et 8b disposées au voisinage de la plate-forme 4, une de chaque côté de la plate-forme et en positions décalées l'une par rapport à l'autre. Ces masselottes 8a et 8b formant des masses thermiques sont notamment constituées d'un métal subissant une transformation de phase à la même température ou, de préférence, à une température légèrement inférieure à celle de l'alliage constituant la pièce à solidifier qui est l'aube 1 dans l'exemple représenté sur les dessins. Le but atteint par cette disposition de masselottes 8a et 8b est de contrôler le sens et la valeur de gradients thermiques dans un plan horizontal perpendiculaire à la direction de propagation du front de solidification dans la pale 3 de l'aube 1, notamment au niveau de la plate-forme entre les bords externes et le centre de la pièce. L'apparition d'un grain parasite au niveau de la plate-forme 4 est ainsi évitée et ces dispositions permettent d'obtenir une pièce saine telle qu'une aube 1 monocristalline sans défaut. En cours de solidification, lesdites masses thermiques 8a et 8b dégagent une chaleur latente qui vient réchauffer la périphérie de la plate-forme 4 de l'aube 1.

Cette solution conforme à l'invention présente notamment l'avantage d'une absence de liaisons entre la masselotte et la pièce à couler, ce qui évite l'apparition de défauts postérieurement à la coulée, comme cela a été précédemment noté dans les techniques connues antérieures.

La taille des masses thermiques à utiliser pour chaque application particulière ainsi que la forme et la position des masses sont déterminées en fonction des géométries particulières de pièce et notamment des zones critiques qu'elle comporte. La taille doit notamment être suffisante pour ralentir la solidification de la partie de pièce considérée. La masse thermique présente une forte capacitance thermique et procure un fort dégagement de chaleur latente ; son facteur de forme doit répondre à la condition de surface minimale en regard de la zone froide lorsque ladite masse est placée à la hauteur des écrans thermiques du dispositif de coulée. La masse thermique doit par contre présenter une grande surface d'échange thermique par conduction avec la partie critique de pièce, telle que la plate-forme 4 de l'aube 1 donnée comme exemple. Sans présenter de points de contact, la masse doit être la plus proche possible de ladite partie critique de pièce pour favoriser les échanges thermiques par conduction.

Le montage de moule schématisé sur la figure 3 a notamment donné des résultats pleinement satisfaisants dans la coulée d'aubes monocristallines à large plate-forme.

## Revendications

1. Moule de fonderie pour la fabrication de pièces par solidification monocristalline, notamment des aubes (1) pour turbomachine en superalliage, comportant un dispositif de sélection de grain, caractérisé en ce qu'il comporte au moins une masselotte (8a, 8b) placée au voisinage des zones (4) de pièce où est susceptible d'apparaître une germination de grain parasite en cours de solidification dirigée, notamment au voisinage d'une plate-forme (4) d'aube, ladite masselotte (8a, 8b) formant une masse thermique qui est séparée de la pièce coulée et qui ralentit la solidification de ladite zone (4) concernée par échange thermique avec celle-ci.

2. Moule de fonderie selon la revendication 1 dans lequel ladite masselotte (8a, 8b) est constituée d'un métal subissant une transformation de phase à la même température ou légèrement inférieure à celle du métal constituant la pièce (1) à solidifier.

3. Moule de fonderie selon l'une des revendications 1 ou 2 destiné à la fabrication d'aubes (1) monocristallines à plate-forme (4), dans lequel une masselotte (8a, 8b) formant masse thermique est disposée de chaque côté de la plate-forme (4) et à son voisinage, dans une position en diagonale par rapport à ladite plate-forme (4) vue en plan.

## Claims

1. Foundry mould for the manufacture of castings by monocrystalline solidification, especially of turbomachine blades (1) made of superalloy, including a grain selection device, characterized in that it includes at least one riser (8a, 8b) placed in the vicinity of the casting zones (4) in which parasitic grain nucleation is liable to appear in the course of directional solidification, especially in the vicinity of a blade platform (4), the said riser (8a, 8b) forming a thermal mass which is separate from the casting and which slows down the solidification of the said zone (4) in question by heat exchange with the latter.

2. Foundry mould according to Claim 1, in which the said riser (8a, 8b) is constituted from a metal under-going a phase transformation at the same temperature as, or slightly below, that of the metal constituting the casting (1) to be solidified.

3. Foundry mould according to one of Claims 1 and 2, intended for the manufacture of monocrystalline blades (1) with a platform (4), in which mould a riser (8a, 8b) forming a thermal mass is arranged on each side of the platform (4) and in its vicinity, in a diagonal position with respect to the said platform (4) seen in plan.

## Patentansprüche

1. Gießform zur Herstellung von Gegenständen durch monokristalline Erstarrung, insbesondere von Schaufeln (1) für Turbomaschinen aus Superlegierung, mit einer Kornwahlvorrichtung,
dadurch **gekennzeichnet,**
daß sie wenigstens einen Einguß (8a, 8b) in der Nähe von Bereichen (4) des Gegenstands aufweist, wo während gerichteter Erstarrung parasitäre Keimbildung auftreten kann, insbesondere in der Nähe einer Schaufelplatte (4), wobei der Einguß (8a, 8b) eine thermische Masse bildet, die von dem gegossenen Gegenstand getrennt ist und die Erstarrung des betreffenden Bereichs (4) durch Wärmetausch mit diesem verzögert.

2. Gießform nach Anspruch 1, bei der der Einguß (8a, 8b) aus einem Metall besteht, das einen Phasenübergang vollzieht bei der gleichen Temperatur oder bei einer etwas niedrigeren Temperatur als die des Metalls, das den zu erstarrenden Gegenstand (1) bildet.

3. Gießform nach einem der Ansprüche 1 oder 2 zur Herstellung von monokristallinen Schaufeln (1) mit Platten (4), bei der ein Einguß (8a, 8b), der eine thermische Masse bildet, an beiden Seiten der Platte (4) und in deren Nähe vorgesehen ist in einer bei Aufsicht diagonalen Anordnung bezüglich der Platte (4).
